Europäisches Patentamt

European Patent Office

Office européen des brevets

(11) Publication number: **0 418 091 A2**

# EUROPEAN PATENT APPLICATION

(21) Application number: 90310060.0

(22) Date of filing: 13.09.90

(51) Int. Cl.⁵: **C23C 14/22,** C23C 14/32, C23C 16/48

(30) Priority: 14.09.89 JP 237293/89

(43) Date of publication of application:
20.03.91 Bulletin 91/12

(84) Designated Contracting States:
DE FR GB

(71) Applicant: NIPPON STEEL CORPORATION
6-3 Otemachi 2-chome Chiyoda-ku
Tokyo 100(JP)

Applicant: NATIONAL RESEARCH INSTITUTE
FOR METALS
2-3-12, Nakameguro
Meguro-ku Tokyo(JP)

(72) Inventor: Chiba, Koichi
1618, Ida, Nakahara-ku
Kawasaki-shi, Kanagawa(JP)

Inventor: Saeki, Masao
1618, Ida, Nakahara-ku
Kawasaki-shi, Kanagawa(JP)
Inventor: Umeda, Hiroshi
1618, Ida, Nakahara-ku
Kawasaki-shi, Kanagawa(JP)
Inventor: Yoshimatsu, Shiro
3-12, Nakameguro 2-chome
Meguro-ku, Tokyo(JP)
Inventor: Ogawa, Yoichi
3-12, Nakameguro 2-chome
Meguro-ku, Tokyo(JP)
Inventor: Ozaka, Tsuyoshi
3-12, Nakameguro 2-chome
Meguro-ku, Tokyo(JP)

(74) Representative: Geering, Keith Edwin et al
REDDIE & GROSE 16 Theobalds Road
London WC1X 8PL(GB)

(54) Preparation of high-purity thin film.

(57) Disclosed is a proces for the gas-phase preparation of a thin film. In this process, atoms or molecules present in the reaction system are irradiated with laser beams having an appropriately selected wavelength, to excite a target atom or molecule, whereby a selective excitation and ionization are effected. The target atom or molecule is separated from another atom or molecule by an electric field to form a high purity thin film, or the target atom or molecule unnecessary for formation of thin film is taken out by an electric field, and a high-purity thin film is formed. Furthermore, the selectively excited atom or molecule is selectively reacted with an atom or molecule independently introduced, and the reaction product is separated to form a high purity thin film, or the reaction product unnecessary for a formation of a thin film is taken out and a high purity thin film is formed. A thin film having a high purity can be prepared according to this process.

EP 0 418 091 A2

## PREPARATION OF HIGH-PURITY THIN FILM

## BACKGROUND OF THE INVENTION

### 1. Field of the Invention

The present invention relates to an improvement in the conventional process for the preparation of a thin film, in which a thin film having excellent characteristics or a thin film having a high purity is prepared. More specifically, by concentrating on the inherent discrete energy level possessed by an atom or molecule and utilizing the wavelength selectivity and coherency of laser beams, a specific impurity atom or impurity molecule is selectively separated or removed, or only an atom or molecule making a contribution to the formation of a thin film is selectively taken out, whereby a high-purity thin film is prepared.

### 2. Description of the Related Art

As one condition for improving the characteristics of a thin film, the formation of a thin film having a high purity is required, and to form a thin film having higher characteristics, a material having a high purity is required. Moreover, in the case of a thin film having superior characteristics, it is considered that a certain specific element may have an influence on the entire characteristics of the thin film, and will reduce such characteristics. In this case, it is necessary to remove only this element.

Currently, to form a thin film having a high purity, a material which has been highly purified is used. As the purification process for forming a material having a high purity, many processes such as the solvent extraction process, the zone melting process and the distillation process have been adopted, but according to these processes, it is impossible to purify a target atom or molecule during the process of forming a thin film. Namely, to prepare a thin film having a high purity, it is necessary to remove a specific impurity element or impurity molecule during the process of forming a thin film, or to increase the purity during the process of forming a thin film, but a process capable of realizing this removal or purification has not been reported.

## SUMMARY OF THE INVENTION

A primary object of the present invention is to provide a process in which a high-purity thin film is prepared by realizing the purification of an atom or molecule of a material during the process of forming a thin film, which is impossible according to the conventional purification techniques.

An atom or molecule in the gaseous state has inherent energy levels discretely present, and if a light having a wavelength agreeing with the energy difference is absorbed in the atom or molecule, the atom or molecule can be excited to the upper level. Furthermore, if the excited atom is irradiated with a light having an appropriate wavelength that can be selectively absorbed by the excited atom, the atom can be excited to a much higher level, and finally, the atom or molecule can be ionized.

Since the atom or molecule in the excited state is more activated than the atom or molecule in the ground state, the atom or molecule in the excited state has a rich reactivity and is highly reactive with other atoms or molecules. Accordingly, if a target atom or molecule is appropriately and selectively excited and is selectively reacted with an atom or molecule present in the system, or independently introduced into the system, only a reaction product of the specific atom or molecule can be produced.

According to the present invention, based on the above-mentioned principle, a thin film is prepared by irradiating an atom or molecule in the gas phase state with a light having a good wavelength selectivity, such as laser beams, to ionize the target atom or molecule, and increasing the purity by selectively removing or taking out the target atom or molecule by using an electric field or the like.

Furthermore, according to the present invention, an atom or molecule in the gas phase state is irradiated with a light having a good wavelength selectivity, such as laser beams, to selectively excite the target atom or molecule, the excited atom or molecule is selectively reacted with an atom or molecule present in the system or an atom or molecule independently introduced into the system, and the reaction product is separated and removed or a film is prepared from the reaction product.

By the gas phase process referred to in the present invention is meant a process for preparing a thin film by utilizing PVD, sputtering, ion plating or the like. As the atom and molecule present in the reaction system of the gas phase process, there can be mentioned atoms and oxide molecules evaporated and generated by heating a metal material or the like by resistance heating, electron beam heating or the like, and silane gas and hydrogen gas introduced as the gas. These features will now be described in detail.

In accordance with one aspect of the present invention, there is provided a process for the preparation of a high-purity thin film, which comprises irradiating atoms or molecules present in the system with laser beams capable of reacting selectively with a specific target atom or molecule to ionize the target atom or molecule, and forming a thin film while removing only the specific atom or molecule by an electric field or taking out only the atom or molecule necessary for the formation of a thin film. When removal of a specific impurity element is desired, there is advantageously adopted a process in which the impurity element is ionized and removed. Where the removal of a plurality of impurities is desired, a process for preparing a high-purity film while ionizing and taking out only an atom or molecule necessary for the formation of a thin film is advantageously adopted, because the purification can be increased by using a small number of lasers.

In accordance with another aspect of the present invention, there is provided a process for the preparation of a high-purity thin film, which comprises irradiating atoms or molecules in the system with laser beams to selectively excite a specific atom or molecule to an excited state such that the specific atom or molecule is rendered highly active to have a rich reactivity, reacting the excited atom or molecule with the atom or molecule present in the system or with an atom or molecule independently introduced in the system, and separating and removing the reaction product of the specific atom or molecule or forming a thin film only from said reaction product. If a target specific atom or molecule is excited to the excited state by laser beams and a molecule having a high reactivity, such as a molecule containing a halogen atom, is introduced into the system, the atom or molecule is selectively reacted with the introduced molecule. In this case, if the molecule to be independently introduced is converted to the form of a beam and the target atom or molecule in the excited state is irradiated with this molecular beam, the reaction product is influenced by the molecular beam introduced by the irradiation and the orbit of the reaction product is changed to deviate from the original beam orbit. Accordingly, the beam of the atom or molecule of the material can be separated from the beam of the reaction product by a collimator or the like.

As the light source for causing the reaction of the photo-exciting purification, a light source having a wavelength variability, a narrow spectral width sufficient to effect selective light absorption, and a sufficient light intensity can be used. As the light source satisfying these requirements, there can be considered a monochromic light separated from a light of a xenon lamp by monochromer. Currently, however, the use of a laser is a most effective and efficient means. In the photo-exciting purification, a target atom or molecule is selectively excited and ionized by utilizing the energy difference between inherent exciting levels of the atom or molecule, and utilizing the wavelength selectivity and coherency of laser beams. Accordingly, in principle, this purification can be applied to all atoms or molecules. As the scheme for effecting even an ionization while performing a photo-exciting purification, there can be mentioned a process in which a selective excitation and ionization can be performed in one stage without passage through an intermediate level by one laser beam wavelength while utilizing a Rydberg state or an automatic ionization level, a process in which ionization is accomplished in two stages through one intermediate level, and a process in which ionization is accomplished in multiple stages through at least two intermediate levels. If a laser having an appropriate level capable of performing selective ionization and an appropriate oscillation wavelength is used, n-wavelength m-stage ionization can be performed at an optional wavelength in an optical number of stages of the light reaction. If the number of stages of the light reaction is increased, since each light-absorbing reaction is selective, the selectivity of the entire photo-exciting purification process probably will be increased. Ionization can be accomplished by combining laser beams with another energy while maintaining the selectivity by laser beams. For example, there can be adopted a process wherein a target atom is selectively excited to the Rydberg level by laser beams and is then ionized by an electric field. Similarly, a target specific atom or molecule in the excited state can be selectively reacted with another atom or molecule. In this case, the selective excitation causes the reaction of the excited atom or atom at the intermediate level, explained above with reference to the selective ionization.

## BRIEF DESCRIPTION OF THE DRAWINGS

Figure 1 shows the state of the photo-exciting ionization spectrum of neodymium isotope (the mass number is 142), wherein the mass number is plotted on the abscissa and the ion intensity is plotted on the ordinate by an optional unit. Fig. 1-(A) shows the mass spectrum obtained by superposed irradiation with dye laser beams (574.97 nm) and excimer laser beams, Fig. 1-(B) shows the mass spectrum obtained by single irradiation with excimer laser beams, and Fig. 1-(C) shows the mass spectrum obtained by single irradiation with dye laser beams (574.97 nm);

Fig. 2 shows the results of the mass analysis of the starting material, in which the mass is plotted on the abscissa and the ion intensity is plotted on the ordinate by an optional unit; and

Fig. 3 shows the results of the mass analysis of the obtained thin film, in which the mass is plotted on the abscissa and the ion intensity is plotted on the ordinate by an optional unit.

## DESCRIPTION OF THE PREFERRED EMBODIMENTS

The present invention will now be described in detail with reference to the embodiments thereof.

An embodiment of the process for preparing a high-purity thin film by using neodymium metal as the starting material is first described. Neodymium belongs to the rare earth element group. Since rare earth elements have similar chemical properties to one another, it is difficult to prepare a high-purity metal by separating them from one another. An excimer laser and an excimer laser-excited dye laser are used as the exciting laser, and a vapor of neodymium metal is generated in a reaction vessel by using electron beams and a metal vapor beam is formed by a collimator. At this step, impurities contained in the starting neodymium metal are simultaneously evaporated and contained in the metal vapor. In the reaction vessel, the metal vapor beam is irradiated with the above-mentioned laser beams, and by selecting an appropriate wavelength, a selective excitation and ionization are caused. Rare earth metals present as impurities, such as praseodymium and samarium, are not ionized because they have a different exciting energy from neodymium. The neodymium atom selectively ionized by laser beams is taken out by an electric field applied between electrodes arranged in the reaction vessel, whereby the neodymium atom is separated from neutral atoms or molecules, and the separated neodymium atom is adsorbed on a substrate to form a thin film. Since the ionization energy for neodymium is at a level of 44562 cm$^{-1}$, in the experiment system of the present embodiment, because of the limitation of oscillating wavelengths of the dye laser, a light-absorbing reaction of at least two stages passing through an appropriate intermediate level is necessary for the ionization of neodymium. A laser beam for selectively exciting neodymium to an intermediate level can be appropriately selected according to the exciting level of neodymium selected as the intermediate level. For example, a wavelength of 574.9 nm causing the transfer of the neodymium atom from 0 cm$^{-1}$ to 17387 cm$^{-1}$ is selected as the oscillation wavelength of the dye laser, and only the neodymium atom is selectively excited to a level of 17387 cm$^{-1}$. Then, the excited neodymium atom is selectively ionized by irradiation with excimer laser beams (308 nm). Although neodymium cannot be ionized by one wavelength alone, by utilizing two kinds of laser beams having different wavelengths, neodymium can be ionized through one intermediate level.

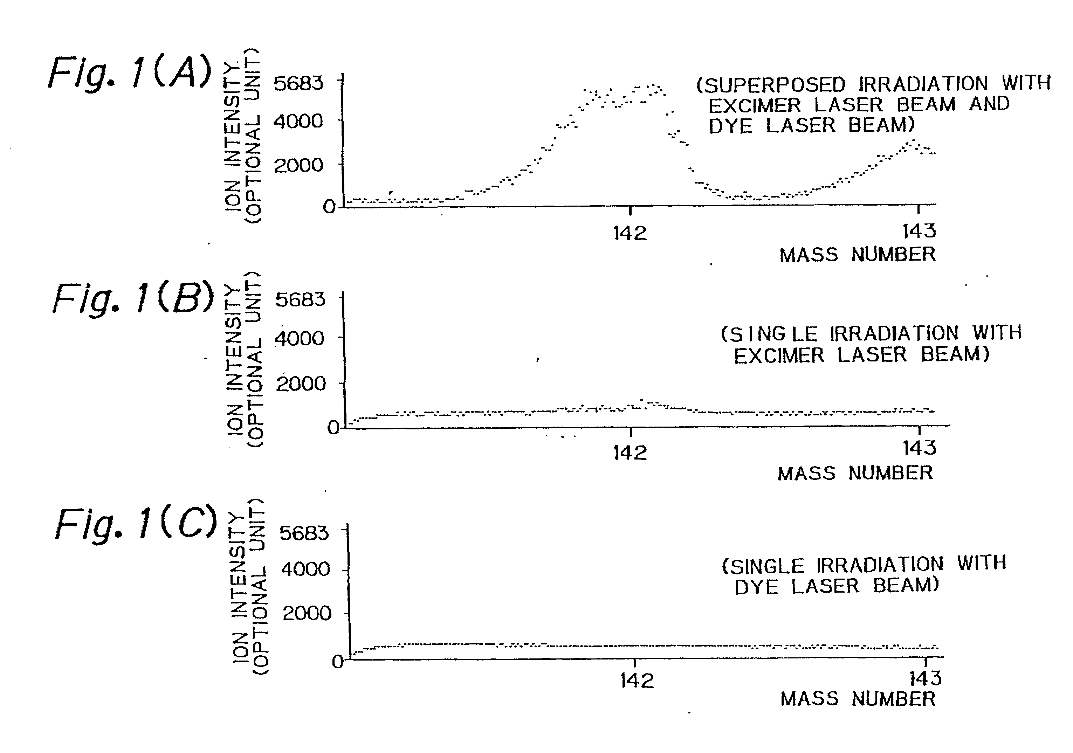

Either a continuous oscillation laser or a pulse oscillation laser can be used as the laser for the excitation. When the pulse oscillation laser is used for the excitation, the irradiation timings of both the laser beams may be the same, or these timings can be deviated from each other if an interval is sufficiently short, compared with the excitation life time of the atom. The mass spectrum showing the selective photo-ionization is illustrated in Fig. 1. Namely, Fig. 1 shows the state of the photo excited ionization spectrum of neodymium isotope (the mass number is 142), in which the mass number is plotted on the abscissa and mass numbers of from 141 to 143 are shown, and the ion intensity is plotted on the ordinate by an optional unit. Figure 1-(A) shows the mass spectrum obtained when excimer laser beams and dye laser beams are superposed on each other, and the ion of neodymium is detected. In contrast, in mass spectra of Figs. 1-(B) and 1-(C) obtained by single irradiation with excimer laser beams and single irradiation with dye laser beams, respectively, the neodymium ion is not detected. Namely, an ion of neodymium is not formed by a single irradiation with dye laser beams or excimer laser beams, and only when dye laser beams and excimer laser beams are superposed on each other can a neodymium ion be selectively formed.

According to the present invention, selective ionization can also be accomplished through two intermediate levels. In general, by irradiation with two laser beams corresponding to the two excitation levels, respectively, a target atom can be selectively excited to an intermediate level higher by two ranks, and the excited atom is ionized by a third laser beam. In the case of a neodymium atom however, if the neodymium atom is irradiated with a beam having a wavelength of 577.61 nm corresponding to the transfer from the ground state of 1128 cm$^{-1}$ to the first excitation intermediate level of 18436 cm$^{-1}$, the neodymium atom can be selectively excited to a second excitation intermediate level of 36872 cm$^{-1}$. This is because, in the case of neodymium, the excitation levels of an equal energy difference interval are accidentally present, and the atom excited even to the second excitation intermediate level can be sufficiently ionized by this light energy of the same wavelength. As a result, a selective two-state excitation and ionization can be accomplished by one wavelength.

Conversely, where praseodymium as the impurity atom is ionized and removed by an electric field, since the ionization energy for praseodymium is at a level of 43730 cm$^{-1}$, for example, an excitation level of 20190 cm$^{-1}$ is selected as the intermediate level for two-stage ionization, praseodymium is excited from 0 cm$^{-1}$ by a laser beam having a wavelength of 495.137 nm, and at the same timing, praseodymium is irradiated with a beam (having a wavelength of 308 nm) from the excimer laser, whereby only praseodymium is selectively ionized.

The present invention will now be described in detail with reference to the following examples that by no means limit the scope of the invention.

Example 1

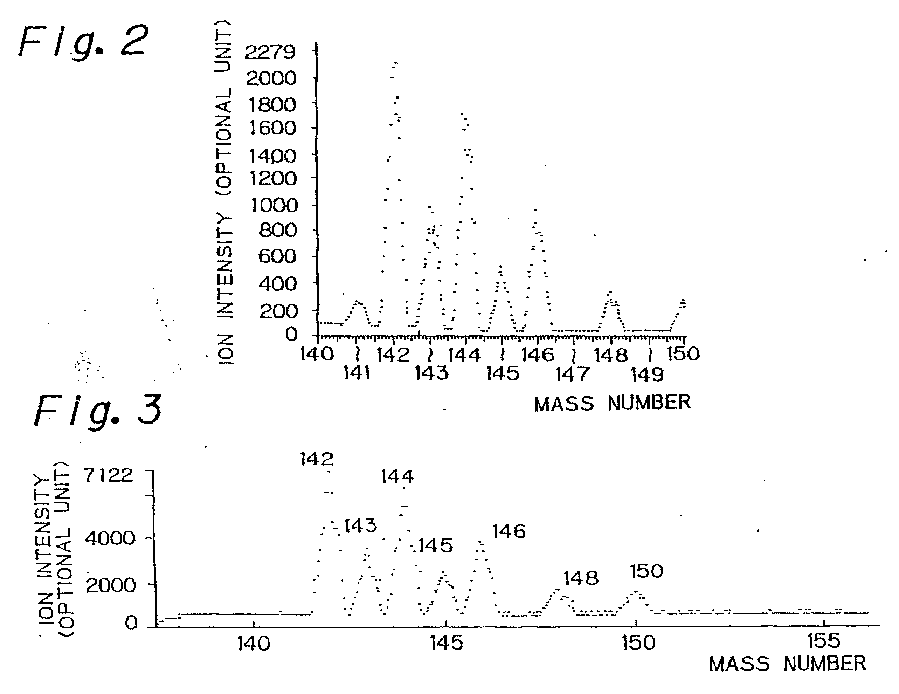

Neodymium metal containing 1% of praseodymium was melted by electron beams to form a metal vapor beam, and the metal vapor beam was simultaneously irradiated with a dye laser beam of a wavelength of 574.97 nm selectively exciting only the neodymium atom to an intermediate level and an excimer laser beam having a wavelength of 308 nm, whereby only neodymium was ionized by one-wavelength two-stage ionization. The ionized neodymium atom was taken out by an electric field to prepare a highly purified thin film. The results of the mass analysis of the starting material and the obtained thin film are shown in Figs. 2 and 3, respectively. Figure 2 shows the results of the mass analysis of the starting material, in which mass numbers of from 140 to 150 are plotted on the abscissa and the ion intensity is plotted on the ordinate by an optional unit. The mass number of 141 indicates the peak of praseodymium. Since praseodymium is a mononuclear element, one peak is observed at the position of 141. Seven isotopes of neodymium are detected at positions of from 142 to 150.

Figure 3 shows the results of the mass analysis of the obtained thin film, in which mass numbers of from 140 to 150 are plotted on the abscissa and the ion intensity is plotted on the ordinate by an optional unit. No peak is observed at the spectrum position of the mass number of 141, and it is seen that praseodymium is not contained in the obtained thin film. Seven isotopes of neodymium are found at positions of mass numbers of from 142 to 150. The formed thin film had a purity of at least 4N, and the purity of the obtained film was about 400 times as high as that of the starting material.

Example 2

Neodymium metal containing 1% of praseodymium was melted by electron beams to form a metal vapor beam, and the vapor beam was simultaneously irradiated with a laser beam of a wavelength of 495.137 nm selectively exciting only the praseodymium atom to an intermediate level and an excimer laser beam having a wavelength of 308 nm, whereby only praseodymium is ionized by a one-wavelength two-stage ionization. The above-mentioned 6416 beam is vacuum-deposited on a substrate while removing the ionized praseodymium atom by an electric field, whereby a thin film having a purity of 4N was obtained.

## Claims

1. A process for producing a high-purity thin film in gas phase, which comprises irradiating atoms or molecules present in a reaction vessel with laser beams to selectively ionize an atom or molecule necessary for formation of a thin film, taking out the ionized atom or molecule by an electric field in the reaction vessel, and forming a high-purity thin film with the ionized atom or molecule.

2. A process according to claim 1, wherein the atom or molecule in the gas phase is irradiated with laser beams having one selected wavelength to excite the atom or molecule to one intermediate energy level and selectively ionize the atom or molecule in two stages.

3. A process according to claim 1, wherein the atom or molecule in the gas phase is irradiated with laser beams having at least two selected wavelengths to selectively ionize the atom or molecule in multiple stages through at least two intermediate energy levels.

4. A process according to claim 1, wherein atoms or molecules are generated from the material metal in the reaction vessel by vaporization, sputtering or abrasion.

5. A process according to claim 1, wherein atoms or molecules are silane, halogenized hydrocarbons, hydrogen, and decomposed products thereof.

6. A process according to claim 1, wherein the method of forming a high-purity thin film is one of CVD and PVD.

7. A process for the gas-phase preparation of a high-purity thin film, which comprises irradiating atoms or molecules present in a reaction vessel with laser beams having a selected wavelength to selectively excite an atom or molecule necessary for formation of a thin film, reacting the selectively excited atom or molecule with other atom or molecule present in the reaction vessel or introduced into the reaction vessel from the outside, and forming a thin film from the reaction product.

8. A process for the gas-phase preparation of a high-purity thin film, which comprises irradiating atoms or molecules present in a reaction vessel with laser beams to ionize a specific atom or molecule unnecessary for formation of a thin film, removing the ionized atom or molecule by an electric field in the reaction vessel and causing the remaining atom or molecule to be adsorbed on a substrate to form a high-purity thin film.

9. A process for the gas-phase preparation of a high-purity thin film, which comprises irradiating atoms or molecules present in a reaction vessel to selectively excite an atom or molecule unnecessary for formation of a thin film, reacting the selectively excited atom or molecule with other atom or molecule present in the reaction vessel or introduced into the reaction vessel from the outside, removing the reaction product, and causing the remaining atom or molecule to be adsorbed on a substrate to form a high-purity thin film.

Fig. 1(A)

ION INTENSITY (OPTIONAL UNIT)

5683
4000
2000
0

(SUPERPOSED IRRADIATION WITH EXCIMER LASER BEAM AND DYE LASER BEAM)

142                 143
MASS NUMBER

Fig. 1(B)

ION INTENSITY (OPTIONAL UNIT)

5683
4000
2000
0

(SINGLE IRRADIATION WITH EXCIMER LASER BEAM)

142                 143
MASS NUMBER

Fig. 1(C)

ION INTENSITY (OPTIONAL UNIT)

5683
4000
2000
0

(SINGLE IRRADIATION WITH DYE LASER BEAM)

142                 143
MASS NUMBER

EP 0 418 091 A2

Fig. 2

Fig. 3

EP 0 418 091 A2